# EUROPÄISCHE PATENTANMELDUNG

(11) **EP 4 632 393 A1**
(43) Veröffentlichungstag der Anmeldung: **15.10.2025**
(21) Anmeldenummer: 24169896.8
(22) Anmeldetag: 12.04.2024
(51) Int. Cl.: G01R 27/02, G01R 31/59

(54) **VORRICHTUNG, PRÜFANORDNUNG UND VERFAHREN ZUR PRÜFUNG EINER ISOLIERUNG EINES LEITERS**

(71) Anmelder: Lisa Dräxlmaier GmbH, 84137 Vilsbiburg (DE)
(72) Erfinder: Selmeier, Christian, 84155 Bodenkirchen (DE); Härtel, Stefan, 84137 Vilsbiburg (DE); Kagerhuber, Marc, 84494 Neumarkt Sankt Veit (DE)

(57) **Zusammenfassung**

Vorrichtung (1) zur Prüfung einer Isolierung eines Leiters (3) aufweisend: ein Rahmenelement (4) mit einer Durchgangsöffnung (5), ein erstes Abtastelement (7), und ein zweites Abtastelement (8), wobei die Durchgangsöffnung (5) derart ausgebildet ist, sodass der Leiter (2) in einer Längsrichtung des Leiters (6) durch die Durchgangsöffnung (5) durchführbar ist, wobei das erste Abtastelement (7) und das zweite Abtastelement (8) derart am Rahmenelement (4) angeordnet sind, sodass die Isolierung des Leiters (3) an einer ersten Seite (9) durch das erste Abtastelement (7) während der Durchführung des Leiters (2) durch die Durchgangsöffnung (5) berührbar ist und die Isolierung des Leiters (3) an einer zweiten Seite (10) während der Durchführung des Leiters (2) durch die Durchgangsöffnung (5) durch das zweite Abtastelement (8) berührbar ist, wobei die zweite Seite der Isolierung des Leiters (10) der ersten Seite der Isolierung des Leiters (9) gegenüberliegt.

## Beschreibung

### Technisches Gebiet

Die vorliegende Erfindung betrifft eine Vorrichtung zur Prüfung einer Isolierung eines Leiters sowie eine korrespondierende Anordnung, welche die Vorrichtung aufweist. Zudem betrifft die Erfindung ein Verfahren zur Prüfung einer Isolierung eines Leiters.

### Stand der Technik

Leiter wie beispielsweise Kabel oder Stromschienen weisen meist eine Isolierung auf, die als Berührschutz und auch der Vermeidung von Kurzschlüssen dient. Die Isolierung ist dazu auf der Umfangsfläche des Leiters aufgebracht und hat eine geringe elektrische Leitfähigkeit. An Anschlussstellen weisen Leiter meist keine Isolierung auf. Nach der Herstellung eines solchen eine Isolierung aufweisenden Leiters muss sichergestellt werden, dass die Isolierung flächendeckend aufgebracht und folglich die Funktionssicherheit des Leiters gewährleistet ist.

Aus dem Stand der Technik sind unterschiedliche Verfahren bekannt wie die Isolierung eines Leiters geprüft werden kann. Beispielsweise kann der zu prüfende und eine Isolierung aufweisende Leiter in einen Behälter gelegt werden, der mit einer leitfähigen Flüssigkeit gefüllt ist. Wird dann der Leiter, sowie die Flüssigkeit an einer Stromquelle angeschlossen, kann bei einer fehlerhaften Isolierung ein Stromfluss zwischen Leiter und Flüssigkeit detektiert werden.

Aus dem Stand der Technik sind verschiedene Verfahren bekannt, mit denen die Isolierung eines Leiters überprüft werden kann. Beispielsweise kann der zu prüfende Leiter, der eine Isolierung aufweist, in einen Behälter gelegt werden, der mit einer leitfähigen Flüssigkeit gefüllt ist. Wenn der Leiter zusammen mit der Flüssigkeit an eine Stromquelle angeschlossen wird, kann bei einer fehlerhaften Isolierung ein Stromfluss zwischen dem Leiter und der Flüssigkeit festgestellt werden.

Alle bekannten Verfahren und zugehörigen Vorrichtungen aus dem Stand der Technik haben gemeinsam, dass eine Automatisierung dieser Verfahren sowie deren Integration in den laufenden Produktionsprozess nur schwer umsetzbar ist. Insbesondere das zuletzt beschriebene Verfahren erfordert einen hohen manuellen Aufwand: Der Leiter muss vor der Prüfung manuell in die Flüssigkeit gelegt, angeschlossen und nach der Prüfung wieder abgetrocknet werden. Ein derart komplexes Prüfverfahren ist daher zeitaufwendig und lässt sich nur schwer in einen ansonsten hochautomatisierten Herstellungsprozess integrieren. Zudem birgt das zuletzt beschriebene Verfahren ein hohes Verletzungsrisiko für den durchführenden Werker aufgrund der hohen Spannung, die während der Prüfung auf den Leiter aufgebracht wird.

### Beschreibung der Erfindung

Eine Aufgabe der Erfindung ist es daher, unter Einsatz konstruktiv möglichst einfacher Mittel eine Vorrichtung zur Prüfung einer Isolierung eines Leiters, eine korrespondierende Anordnung sowie ein Verfahren zur Prüfung einer Isolierung eines Leiters bereitzustellen, die/ das eine besonders sichere Anwendung bei einer gleichzeitig besonders geringe Zykluszeit ermöglicht.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Gemäß einem ersten Aspekt der Erfindung wird die Aufgabe durch eine Vorrichtung zur Prüfung einer Isolierung eines Leiters gelöst. Die Vorrichtung weist ein Rahmenelement mit einer Durchgangsöffnung, ein erstes Abtastelement und ein zweites Abtastelement auf, wobei die Durchgangsöffnung derart ausgebildet ist, sodass der Leiter in einer Längsrichtung des Leiters durch die Durchgangsöffnung durchführbar ist, wobei das erste Abtastelement und das zweite Abtastelement derart am Rahmenelement angeordnet sind, sodass die Isolierung des Leiters an einer ersten Seite durch das erste Abtastelement während der Durchführung des Leiters durch die Durchgangsöffnung berührbar ist und die Isolierung des Leiters an einer zweiten Seite während der Durchführung des Leiters durch die Durchgangsöffnung durch das zweite Abtastelement berührbar ist und wobei die zweite Seite der Isolierung des Leiters der ersten Seite der Isolierung des Leiters gegenüberliegt.

Die Durchführung des Leiters durch die Durchgangsöffnung kann im Sinne der Erfindung durch das aktive Bewegen des Leiters relativ zur Vorrichtung und/ oder durch das aktive Bewegen der Vorrichtung relativ zum Leiter erfolgen.

Die relative Bewegung der Vorrichtung zum Leiter erlaubt eine Abtastung der den Leiter umgebenden Isolierung mittels der Abtastelemente. Die Abtastung erlaubt Rückschlüsse auf den Zustand der Isolierung. So können mittels der Abtastelemente beispielsweise Risse in der Isolierung ertastet werden. Alternativ oder zusätzlich kann mittels der Abtastelemente zudem auf eine möglicherweise zu dünne Isolierschicht geschlossen werden. Folglich erlaubt die Vorrichtung eine Abtastung der Isolierung des Leiters mittels der erfindungsgemäßen Abtastelemente und so eine besonders schnelle und anwendungssichere Prüfung der Isolierung des Leiters. Dies wiederum erlaubt eine geringe Zykluszeit und eine besonders einfache Integration in den Herstellungsprozess des Leiters.

Die Isolierung des Leiters kann der elektrischen Isolierung eines elektrische leitenden Kerns des Leiters gegenüber der Umgebung dienen. Auch kann die Isolierung dem Schutz des leitenden Kerns des Leiters gegenüber der Umgebung dienen. So kann die Isolierung beispielsweise dem Schutz des leitenden Kerns vor Korrosion durch beispielsweise Rost dienen.

Die Vorrichtung kann zumindest ein weiteres Abtastelement aufweisen. Das weitere Abtastelement kann derart am Rahmenelement angeordnet sein, sodass die Isolierung des Leiters durch das weitere Abtastelement berührbar ist.

In einer Ausführungsform kann der Leiter eine Stromschiene sein.

Eine Stromschiene im Sinne der vorliegenden Erfindung ist insbesondere ein starrer Leiter, dessen Querschnitt im Wesentlichen quaderförmig oder rund sein kann.

Die erfindungsgemäße Vorrichtung ist besonders geeignet zur Prüfung der Isolierung von Stromschienen. Stromschienen sind starr, sodass eine Relativbewegung der Stromschiene und der Vorrichtung zueinander zur Prüfung der Isolierung der Stromschiene besonders schnell und anwendungssicher durchführbar ist. Dies hat wiederum eine besonders geringe Zykluszeit bei besonders einfacher Integrierbarkeit in den Herstellungsprozess der Stromschiene zur Folge.

In einer weiteren Ausführungsform kann die Vorrichtung ein erstes Führungselement und ein zweites Führungselement zur Führung des elektrischen Leiters entlang zweier gegenüberliegender Seiten des Leiters durch die Durchgangsöffnung aufweisen, wobei das erste Führungselement und das zweite Führungselement zumindest teilweise innerhalb der Durchgangsöffnung angeordnet sind.

Das Vorsehen von Führungselementen erlaubt eine besonders prozesssichere und schnelle Bewegung des Leiters und der Vorrichtung zueinander. Insbesondere kann so sichergestellt werden, dass eine ungewollte Kollision des Rahmenelementes mit dem Leiter vermieden wird.

In einer weiteren Ausführungsform kann das erste Führungselement eine rotierbare erste Führungsrolle zur Führung des Leiters durch die Durchgangsöffnung und/ oder das zweite Führungselement eine rotierbare zweite Führungsrolle zur Führung des Leiters durch die Durchgangsöffnung aufweisen.

Die Nutzung einer Führungsrolle als Führungselement erlaubt eine besonders prozesssichere und schnelle Führung des Leiters durch die Durchgangsöffnung der Vorrichtung.

Die erste Führungsrolle kann derart angeordnet sein, sodass eine erste Führungsrollenrotationsachse der ersten Führungsrolle quer zur Längserstreckung des Leiters anordenbar ist, und/ oder die zweite Führungsrolle kann derart angeordnet sein, sodass eine zweite Führungsrollenrotationsachse der zweiten Führungsrolle quer zur Längserstreckung des Leiters anordenbar ist.

Die erste Führungsrolle kann derart ausgebildet und angeordnet sein, sodass die erste Führungsrolle schwenkbar, besonders bevorzugt schwenkbar um eine erste Schwenkachse, ist. Die erste Schwenkachse kann parallel zur ersten Führungsrollenrotationsachse angeordnet sein. Besonders bevorzugt ist die erste Schwenkachse näher am Rahmenelement angeordnet als die erste Führungsrollenrotationsachse.

Die zweite Führungsrolle kann derart ausgebildet und angeordnet sein, sodass die zweite Führungsrolle schwenkbar, besonders bevorzugt schwenkbar um eine zweite Schwenkachse, ist. Die zweite Schwenkachse kann parallel zur zweiten Führungsrollenrotationsachse angeordnet sein. Besonders bevorzugt ist die zweite Schwenkachse näher am Rahmenelement angeordnet als die zweite Führungsrollenrotationsachse.

Die erste Führungsrolle und/ oder die zweite Führungsrolle kann frei rotierend ausgebildet sein.

Die erste Führungsrolle und/ oder die zweite Führungsrolle kann aktiv drehbar sein, sodass der Leiter mittels der Führungsrolle durch die Durchgangsöffnung bewegbar ist.

In einer weiteren Ausführungsform kann die Vorrichtung, das erste Abtastelement, das zweite Abtastelement, das erste Führungselement, das zweite Führungselement und/ oder das Rahmenelement elektrisch leitend ausgebildet sein und an einer Spannungsquelle angeschlossen sein, um eine Spannungsdifferenz gegenüber dem Leiter anzulegen.

Durch das Anlegen einer Spannungsdifferenz zwischen Leiter und Elementen der Vorrichtung, insbesondere dem ersten Abtastelement und dem zweiten Abtastelement, kann auf besonders effiziente, das heißt schnelle und prozesssichere, sowie exakte Weise die Isolierung geprüft werden. Im Falle eines Stromflusses zwischen Leiter und den ebenfalls an der Spannungsquelle angeschlossenen Elementen der Vorrichtung kann davon ausgegangen werden, dass die Isolierung fehlerhaft ist und keine ausreichenden Isoliereigenschaften aufweist.

Alternativ können der Leiter an einer ersten Spannungsquelle und das erste Abtastelement, das zweite Abtastelement, das erste Führungselement, das zweite Führungselement und/ oder das Rahmenelement an einer zweiten Spannungsquelle angeschlossen sein. Die erste Spannungsquelle und die zweite können derart eingestellt sein, sodass eine Spannungsdifferenz zwischen beiden Spannungsquellen anliegt.

Die Vorrichtung kann eine Messvorrichtung aufweisen welche derart ausgebildet ist, sodass mittels der Messvorrichtung ein Stromfluss zwischen dem Leiter einerseits und der Vorrichtung, dem ersten Abtastelement, dem zweiten Abtastelement, dem ersten Führungselement, dem zweiten Führungselement und/ oder dem Rahmenelement andererseits messbar ist.

Die Vorrichtung, das erste Abtastelement, das zweite Abtastelement, das erste Führungselement, das zweite Führungselement und/ oder das Rahmenelement kann eine elektrisch leitende Beschichtung, beispielsweise eine Grafitbeschichtung, aufweisen.

In einer weiteren Ausführungsform kann das erste Abtastelement und/ oder das zweite Abtastelement federnd, insbesondere mittels einer Spiralfeder und/ oder Blattfeder, mit dem Rahmenelement verbunden sein.

Die federnde Anordnung des ersten Abtastelementes und/ oder des zweiten Abtastelementes am Rahmenelement ermöglicht ein sicheres und gleichmäßiges anliegen des oder der Abtastelemente während der Prüfung am Leiter. Dementsprechend wird eine besonders prozesssichere Prüfung ermöglicht.

In einer weiteren Ausführungsform kann das erste Abtastelement eine erste rotierbare Rolle und/ oder das zweite Abtastelement eine zweite rotierbare Rolle aufweisen.

Die Verwendung von Rollen ermöglicht die geführte Durchführung des Leiters an dem jeweiligen Abtastelement entlang durch die Durchgangsöffnung. So kann beispielsweise die jeweilige Rolle dazu dienen den Leiter entlang eines schlussendlich abtastenden Elementes des jeweiligen Abtastelementes zu führen. Dies erhöht wiederum insbesondere die Prozesssicherheit sowie die Zykluszeit in der Prüfung.

Die erste Rolle und/ oder die zweite Rolle kann derart angeordnet sein, sodass der Leiter, insbesondere die Isolierung des Leiters, durch die erste Rolle und/ oder die zweite Rolle berührbar ist.

Die erste Rolle kann derart angeordnet sein, sodass eine erste Rollenrotationsachse der ersten Rolle quer zur Längserstreckung des Leiters, quer zur ersten
Führungsrollenrotationsachse und/ oder quer zur zweiten Führungsrollenrotationsachse anordenbar ist.

Die zweite Rolle kann derart angeordnet sein, sodass eine zweite Rollenrotationsachse der zweiten Rolle quer zur Längserstreckung des Leiters, quer zur ersten Führungsrollenrotationsachse und/ oder quer zur zweiten Führungsrollenrotationsachse anordenbar ist.

Die erste Rolle und/ oder die zweite Rolle kann frei rotierbar ausgebildet und angeordnet sein.

Die erste Rolle und/ oder die zweite Rolle kann elektrisch leitend ausgebildet sein. Die erste Rolle und/ oder die zweite Rolle kann aus einem elektrisch leitenden Material, wie beispielsweise einem Metall, ausgebildet sein. Alternativ oder zusätzlich kann die erste Rolle und/ oder die zweite Rolle eine elektrisch leitende Beschichtung, beispielsweise eine Grafitbeschichtung, aufweisen.

In einer weiteren Ausführungsform kann die erste Rolle und/ oder die zweite Rolle derart ausgebildet sein, dass bei der Durchführung des Leiters durch die Durchgangsöffnung die erste Rolle und/ oder die zweite Rolle auf der Isolierung des Leiters abrollbar ist.

Die Verwendung von Rollen zum Abfahren des Leiters hat sich als besonders prozesssicher herausgestellt. Die Rollen ermöglichen insbesondere bei Stromschienen eine flächige und damit eine besonders schnelle und prozesssichere Prüfung der Isolierung.

Alternativ oder zusätzlich können die Führungsrollen und/ oder Rollen aktiv antreibbar sein.

In einer weiteren Ausführungsform kann das erste Abtastelement erste Borsten und/ oder das zweite Abtastelement zweite Borsten aufweisen.

Die Verwendung von Borsten zur Abtastung der Isolierung des Leiters hat sich als besonders exakte Methode zur Prüfung der Isolierung herausgestellt. Auch kleinste Risse oder Löcher in der Isolierung können durch die Borsten detektiert werden.

Borsten im Sinne der vorliegenden Erfindung können elastische Elemente mit einer länglichen Erstreckung sein.

Die ersten Borsten und/ oder die zweiten Borsten können derart ausgebildet und angeordnet sein, sodass bei der Durchführung des Leiters durch die Durchgangsöffnung die ersten Borsten und/ oder die zweiten Borsten auf der Isolierung des Leiters entlang bürstbar beziehungsweise entlang berührend bewegbar ist.

Die ersten Borsten und/ oder die zweiten Borsten können elektrisch leitend ausgebildet sein.

Die ersten Borsten und/ oder die zweiten Borsten können aus Metall oder einem anderen elektrisch leitfähigen Material gefertigt sein.

Die ersten Borsten und/ oder die zweiten Borsten kann elastisch ausgebildet sein und/ oder derart ausgebildet sein, sodass die ersten Borsten und/ oder die zweiten Borsten eine definierte Anpresskraft auf die Isolierung des Leiters beim Durchführen des Leiters durch die Durchgangsöffnung ausüben.

Gemäß einem zweiten Aspekt der Erfindung wird die Aufgabe durch eine Prüfanordnung zur Prüfung einer Isolierung eines Leiters gelöst. Die Prüfanordnung weist einen mehrachsigen Manipulator und eine erfindungsgemäße Vorrichtung auf, wobei die Vorrichtung an einem Ende des Manipulators angeordnet ist und wobei die Vorrichtung mittels des Manipulators entlang des Leiters bewegbar ist.

Insbesondere das Bewegen der Vorrichtung mittels eines Manipulators ermöglicht eine Automatisierung des Prüfprozesses. Ein automatisierter Prüfprozess resultiert wiederum in eine verkürzte Prüfdauer und damit in eine reduzierte Zykluszeit der Prüfung. Auch wird die Prozesssicherheit wie auch die Arbeitssicherheit der den Prüfprozess begleitenden Person erhöht.

Alternativ oder zusätzlich kann die Prüfvorrichtung fest verbaut sein und einen Manipulator aufweisen, welcher derart ausgebildet ist, sodass die Schiene mittels des Manipulators durch die Durchgangsöffnung durchführbar ist.

In einer weiteren Ausführungsform kann die Prüfanordnung eine erste und eine zweite erfindungsgemäße Vorrichtung aufweisen wobei die zweite Vorrichtung mittels zumindest eines, bevorzugt zweier oder vierer biegeschlaffer Verbindungselemente mit der ersten Vorrichtung verbunden ist.

Die Kombination mehrerer erfindungsgemäßer miteinander verbundener Vorrichtungen, die jeweils der Prüfung dienen, erhöht die Prüfgenauigkeit und damit die Prozesssicherheit.

Gemäß einem dritten Aspekt der Erfindung wird die Aufgabe durch ein Verfahren zur Prüfung einer Isolierung eines Leiters mittels einer erfindungsgemäßen Vorrichtung oder mit einer erfindungsgemäßen Prüfanordnung gelöst. Das Verfahren weist die folgenden Schritte auf: Positionierung des zu prüfenden Leiters innerhalb der Durchgangsöffnung der Vorrichtung, relatives Bewegen der Prüfanordnung und/ oder des Leiters in Richtung einer Längserstreckung des Leiters, sodass das erste Abtastelement und das zweite Abtastelement die Isolierung des Leiters während der relativen Bewegung berühren und Bestimmen einer Eigenschaft der Isolierung des Leiters auf Basis einer mittels der Abtastelemente erfassten Messgröße.

Das erfindungsgemäße Verfahren erlaubt auf besonders effiziente, das heißt schnelle und prozesssichere Weise, eine Abtastung der Isolierung des Leiters mittels der erfindungsgemäßen Vorrichtung bzw. Prüfanordnung. Dies wiederum erlaubt eine geringe Zykluszeit und besonders einfache Integration in den Herstellungsprozess des Leiters.

In einer weiteren Ausführungsform kann das Verfahren zusätzlich den folgenden Verfahrensschritt umfassen: Anlegen einer Differenzspannung zwischen dem ersten Abtastelement und dem zweiten Abtastelement einerseits und der zu prüfenden Leitung andererseits, wobei das Erfassen der Messgröße das Erfassen eines Stromflusses zwischen dem Leiter und dem ersten Abtastelement sowie zwischen dem Leiter und dem zweiten Abtastelement umfasst, und wobei das Bestimmen einer Eigenschaft der Isolierung des Leiters das Bestimmen einer Konduktivität der Isolierung des Leiters umfasst.

Insbesondere durch das Bestimmen der Konduktivität der Isolierung kann auf besonders effiziente Weise die Haupteigenschaft der Isolierung geprüft werden.

Alternativ oder zusätzlich kann auch eine haptische Abtastung der Isolierung des Leiters durch die Abtastelemente erfolgen. Unebenheiten, Risse, Löcher oder sonstige Oberflächenbeschaffenheiten der Isolierung lassen ebenfalls Rückschlüsse auf die Funktionstüchtigkeit der Isolierung des Leiters zu.

### Kurze Figurenbeschreibung

Nachfolgend werden zwei vorteilhafte Ausführungsbeispiel der Erfindung unter Bezugnahme auf die begleitenden Figuren erläutert. Es zeigen:
Figur 1 eine isometrische Ansicht der erfindungsgemäßen Vorrichtung gemäß einem ersten Ausführungsbeispiel,
Figur 2 eine Draufsicht der erfindungsgemäßen Vorrichtung gemäß dem ersten Ausführungsbeispiel,
Figur 3 eine isometrische Ansicht der erfindungsgemäßen Prüfanordnung gemäß dem zweiten Ausführungsbeispiel.

### Ausführliche Figurenbeschreibung

Die Figuren sind lediglich schematische Darstellungen und dienen nur der Erläuterung der Erfindung. Gleiche oder gleichwirkende Elemente sind durchgängig mit den gleichen Bezugszeichen versehen.

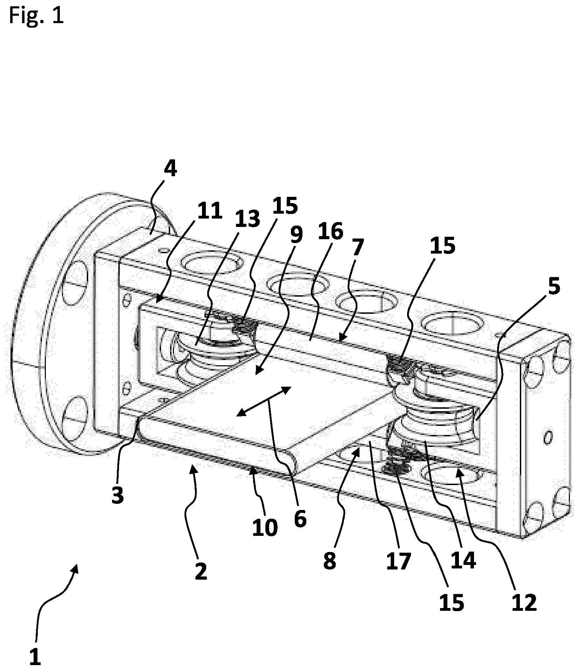

Figur 1 zeigt eine Vorrichtung 1 gemäß einem ersten Ausführungsbeispiel. Die Vorrichtung 1 weist ein Rahmenelement 4 auf, welche eine Durchgangsöffnung 5 bildet. Zudem weist das Rahmenelement 4 eine Anschlussplatte 21 auf, welche zum Anschluss der Vorrichtung 1 an beispielsweise einen nicht dargestellten Manipulator dient. Innerhalb der Durchgangsöffnung 5 wird der mit einer Isolierung 3 umhüllte Leiter 2 angeordnet, dessen Isolierung 3 mit der Vorrichtung 1 geprüft werden soll. In den Figuren ist der zu prüfende Leiter 2 eine Stromschiene mit einem im wesentlichen stadionförmigen Querschnitt. Die geometrische Form "Stadion" beschreibt dabei ein Rechteck, wobei direkt an zwei gegenüberliegenden Enden des Rechteckes Halbkreise die Form abschließen. Der Leiter 2 hat eine längliche Erstreckung. Die Isolierung des Leiters 3 bedeckt die Oberfläche des Leiters 2 weitestgehend, lediglich die Stirnenden des Leiters 2 sind nicht mit der Isolierung 3 bedeckt. Auch kann der Leiter 2 weitere Flächen aufweisen, die nicht von Isolierung 3 bedeckt sind. Jene nicht mit Isolierung 3 bedeckten Flächen können beispielsweise als Anschlussstellen fungieren. Auch denkbar ist es ebenfalls die Stirnflächen des Leiters 2 mit der Isolierung 3 zu überziehen.

Innerhalb der Durchgangsöffnung sind ein erstes Abtastelement 7 sowie ein zweites Abtastelement 8 angeordnet und mit dem Rahmenelement 4 verbunden. Jedes dieser Abtastelemente 7, 8 weist eine rotierbare Rolle 16, 17 auf. Die rotierbaren Rollen 16, 17 dienen schlussendlich der Kontaktierung der Isolierung des Leiters 3, während der Leiter 2 in Längsrichtung 6 dessen Erstreckung relativ zur Vorrichtung 1 bewegt wird. Dazu kann die Vorrichtung 1 mittels des nicht dargestellten Manipulators entlang der Längserstreckung des Leiters 2 bewegt werden. Währenddessen kann der Leiter 2 ortsfest fixiert sein und /oder selbst entsprechend bewegt werden. Auch denkbar ist eine ortsfeste Fixierung der Vorrichtung 1 und das Durchführen des Leiters 2 durch die Durchgangsöffnung 5. Dazu könnte beispielsweise ein Transportband verwendet werden. Die erste Rolle 16 steht während der Prüfung im Kontakt mit der ersten Seite der Isolierung des Leiters 9 und rollt auf jener ab, wenn die Vorrichtung 1 relativ zum Leiter 2 bewegt wird. Die zweite Rolle 17 steht zugleich im Kontakt mit der zweiten Seite der Isolierung des Leiters 10 und rollt auf jener ab, wenn die Vorrichtung 1 relativ zum Leiter 2 bewegt wird. Die erste Seite der Isolierung des Leiters 9 liegt dabei der zweiten Seite der Isolierung des Leiters 10 gegenüber.

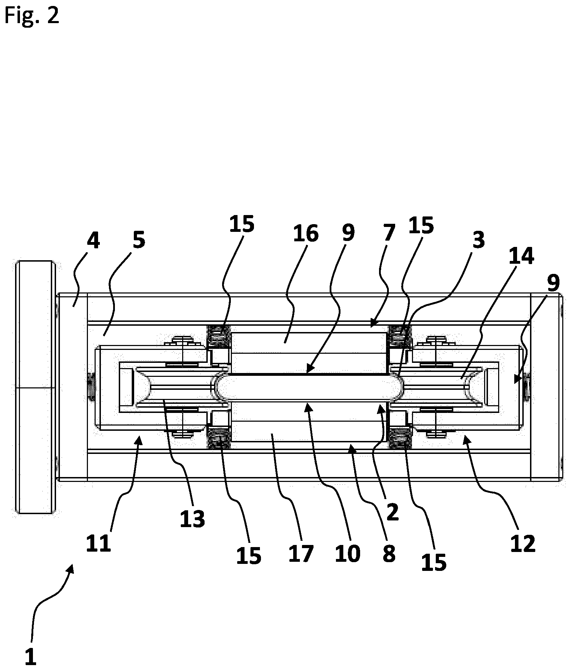

Außerdem weist die Vorrichtung 1 gemäß dem ersten Ausführungsbeispiel ein erstes Führungselement 11 sowie ein zweites Führungselement 12 auf. Insbesondere aus Fig. 2 ist ersichtlich, dass die Führungselemente 11, 12 innerhalb der Durchgangsöffnung 5 angeordnet sind und direkt mit dem Rahmenelement 4 verbunden sind. Die Führungselemente 11, 12 dienen im wesentlichen der Führung des Leiters 2 durch die Durchgangsöffnung 5. Mittels der Führungselemente 11, 12 sowie der Abtastelemente 7, 8 kann die Bewegungsrichtung des Leiters 2 innerhalb der Durchgangsöffnung festgelegt werden. Wie in den Figuren 1 und 2 zu sehen ist weisen das erste Führungselement 11 eine erste Führungsrolle 13 sowie das zweite Führungselement 12 eine zweite Führungsrolle 14 auf. Die Führungsrollen 13, 14 stehen während der Prüfung der Isolierung des Leiters 3 im direkten Kontakt mit jener Isolierung 3. Der Leiter in Form einer Stromschiene 2 weist im wesentlichen vier Seiten auf. Neben der bereits erörterten ersten Seite 9 und der zweiten Seite der Isolierung des Leiters 10 weist die Stromschiene zwei sich in Längsrichtung 6 erstreckende weitere Seiten auf, welche durch die Führungsrollen 13, 14 berührt werden. Um ein Bewegen des Leiters 2 in Längsrichtung 6 innerhalb der Durchgansöffnung 5 zu ermöglichen, sind sowohl die Führungsrollen 13, 14 wie auch die Rollen 16, 17 frei rotierend ausgebildet. Die Führungsrollen 13, 14 und Rollen 16, 17 sind derart angeordnet, sodass sich die Rotationsachsen der Führungsrollen 13, 14 im wesentlichen quer zu den Rotationsachsen der Rollen 16, 17 und wiederum im wesentlich quer zur Längsrichtung 6 erstrecken. Auch denkbar sind aktiv antreibbare Führungsrollen 13, 14 und/ oder Rollen 16, 17.

Insbesondere aus Fig. 2 ist ersichtlich, dass die Führungselemente 11, 12 drehbar am Rahmenelement 4 angeordnet sind. Die Rotationsachsen der Führungselemente 11, 12 erstrecken sich quer zu den Rotationsachsen der Führungsrollen 13, 14. Durch die genannte Anordnung und Ausgestaltung der Führungselemente 11, 12 kann sichergestellt werden, dass die Führungsrollen 13, 14 auch die Prüfung der Isolierung 3 einer gebogenen Stromschiene 2 bzw. eines gebogenen Leiters 2 ermöglicht. Um die Variabilität der Führungsrollen 13, 14 weiter zu erhöhen könnten die Führungselemente 11, 12 schwenkbar an dem Rahmenelement 4 angeordnet sein.

Gemäß dem ersten Ausführungsbeispiel erfolgt die Prüfung der Isolierung durch das Anlegen einer Spannungsdifferenz zwischen dem Leiter 2 und den Rollen 16, 17 der Vorrichtung 1. Dazu ist der Leiter 2 sowie die Rollen 16, 17 elektrisch mit einer nicht dargestellten Spannungsquelle verbunden. Die während der Prüfung bestehende Spannungsdifferenz führt dann zu einem Stromfluss zwischen Leiter 2 und den Rollen 16, 17, wenn die Isolationseigenschaften der Isolierung des Leiters 3 stellenweise nicht ausreichend ist. Ein Riss, ein Loch oder eine teilweise zu dünne Isolierung könnten beispielsweise Fehler in der Isolierung 3 sein, welche die Isolationseigenschaften der Isolierung 3 reduzieren und zum beschriebenen Stromfluss führen. Mit anderen Worten wird die Konduktivität der Isolierung des Leiters 3 bestimmt und auf Basis der gemessenen Konduktivität auf Fehler in der Isolierung des Leiters 3 geschlossen. Zusätzlich könnten ebenfalls die Führungsrollen 13, 14 derart an die Spannungsquelle angeschlossen werden, sodass an die Führungsrollen 13, 14 das gleiche Spannungsniveau wie an die Rollen 16, 17 angelegt werden kann. Dies ermöglicht das Prüfen aller sich in Längsrichtung 6 erstreckender Seiten der Isolierung des Leiters 3. Zur Messung des Stromflusses kann die Stromquelle mit einem ebenfalls nicht dargestellten Strommesser verbunden sein.

In den Figuren 1 und 2 ist zu sehen, dass die Rollen 16, 17 federnd gelagert sind. Die Anbindung der Abtastelemente 7, 8 an das Rahmenelement 4 erfolgt mittels Spiralfedern 15, sodass ein über die Prüfungsdauer durchgängiger Kontakt der Rollen 16, 17 mit der Isolierung des Leiters 3 ermöglicht wird.

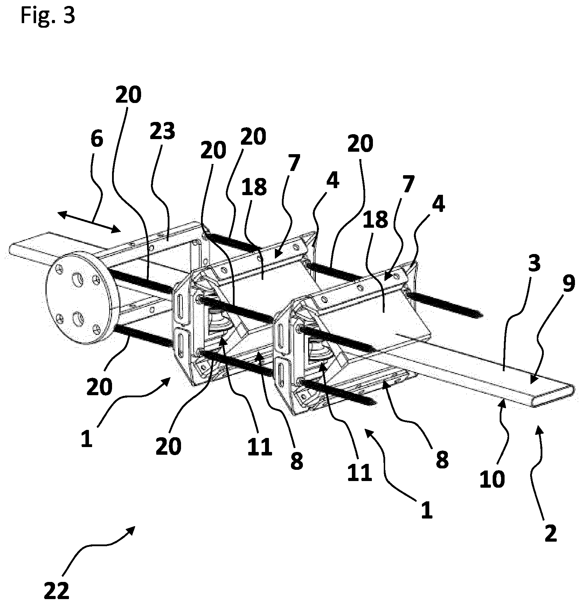

In Figur 3 wird eine Prüfanordnung 22 gemäß einem zweiten Ausführungsbeispiel gezeigt, welche zwei Vorrichtungen 1 gemäß einem zweiten Ausführungsbeispiel aufweisen. Die Vorrichtungen 1 sind mittels Verbindungselemente 20 miteinander verbunden. Vier Verbindungselemente 20, wobei eins der vier Verbindungselemente 20 in Figur 3 nicht erkennbar ist, sind mit den Rahmenelementen 4 der jeweiligen Vorrichtungen 1 verbunden. Die Verbindungselemente 20 sind dabei insbesondere ausschließlich auf Zug belastbar. Beide Vorrichtungen 1 sind dazu derart angeordnet, sodass die Vorrichtungen 1 in Längsrichtung 6 entlang dem Leiter 2 angeordnet sind. Zudem ist ein Befestigungsrahmen 23 ebenfalls mittels vierer Verbindungselemente 20 mit einer der Vorrichtungen 1 verbunden und dient der Anbindung der genannten Elemente an einen nicht dargestellten Manipulator. Das heißt beide Vorrichtungen 1 sowie der Befestigungsrahmen 23 sind in Längsrichtung 6 entlang dem Leiter 2 angeordnet. Alternativ könnte auch auf die Verwendung eines Befestigungsrahmens 23 verzichtet werden und stattdessen eine Vorrichtung 1 mit Anschlussplatte 21 ähnlich dem ersten Ausführungsbeispiel vorgesehen werden. Zudem könnte die Verbindung zweier Vorrichtungen 1 und/ oder der Verbindung einer Vorrichtung 1 mit dem Befestigungsrahmen 23 auch mittels zweier Verbindungselemente 20 oder gar mittels nur eines Verbindungselementes 20 erfolgen.

Alternativ oder zusätzlich könnte die Prüfanordnung 22 weitere Vorrichtungen 1 aufweisen, die jeweils entsprechend mittels Verbindungselemente 20 mit den übrigen Vorrichtungen 1 verbunden sind.

Die Vorrichtungen 1 gemäß dem zweiten Ausführungsbeispiel unterscheiden sich von der Vorrichtung 1 gemäß dem ersten Ausführungsbeispiel durch die am Rahmenelement 4 angeordneten Abtastelemente 7, 8 . So weißt das erste Abtastelement 7 gemäß dem zweiten Ausführungsbeispiel erste Borsten 18 statt einer ersten Rolle 16 auf. Entsprechend weißt das zweite Abtastelement 8 gemäß dem zweiten Ausführungsbeispiel zweite Borsten 19 statt einer zweiten Rolle 17 auf. Die ersten Borsten 18 und zweiten Borsten 19 (im folgenden auch Borsten 18, 19 genannt) sind derart am jeweiligen Abtastelement 7, 8 angeordnet, sodass die ersten Borsten 18 die erste Seite der Isolierung des Leiters 9 und die zweiten Borsten 19 die zweite Seite der Isolierung des Leiters 10 während der Prüfung berühren.

Die Borsten 18, 19 sind elektrisch leitend ausgebildet. Bevorzugt sind die Borsten 18, 19 aus einem elektrisch leitenden Material, wie beispielsweise Metall, ausgebildet. Zwischen den Borsten 18, 19 und dem zu prüfenden Leiter 2 ist während der Prüfung der Isolierung des Leiters 3 eine Spannungsdifferenz angelegt. Dazu können die Borsten 18, 19 einerseits und der Leiter 2 andererseits mit einer nicht dargestellten Stromquelle verbunden sein. Folglich stellen die Borsten 18, 19 der Vorrichtung 1 gemäß dem zweiten Ausführungsbeispiel äquivalente Mittel für die Rollen 16, 17 der Vorrichtung 1 gemäß dem ersten Ausführungsbeispiel dar. Das bezüglich der Vorrichtung 1 gemäß dem ersten Ausführungsbeispiel im Detail erläuterte Verfahren zur Bestimmung der Konduktivität der zu prüfenden Isolierung des Leiters 3 kann entsprechend mit der Vorrichtung 1 gemäß dem zweiten Ausführungsbeispiel durchgeführt werden.

### BEZUGSZEICHENLISTE

- 1: Vorrichtung
- 2: Leiter
- 3: Isolierung des Leiters
- 4: Rahmenelement
- 5: Durchgangsöffnung
- 6: Längsrichtung des Leiters
- 7: Erstes Abtastelement
- 8: Zweites Abtastelement
- 9: Erste Seite der Isolierung des Leiters
- 10: Zweite Seite der Isolierung des Leiters
- 11: Erstes Führungselement
- 12: Zweites Führungselement
- 13: Erste Führungsrolle
- 14: Zweite Führungsrolle
- 15: Spiralfeder
- 16: Erste Rolle
- 17: Zweite Rolle
- 18: Erste Borsten
- 19: Zweite Borsten
- 20: Verbindungselement
- 21: Anschlussplatte
- 22: Prüfanordnung
- 23: Befestigungsrahmen

## Patentansprüche

1. Vorrichtung (1) zur Prüfung einer Isolierung eines Leiters (3) aufweisend:
ein Rahmenelement (4) mit einer Durchgangsöffnung (5),
ein erstes Abtastelement (7),
und ein zweites Abtastelement (8),
wobei die Durchgangsöffnung (5) derart ausgebildet ist, sodass der Leiter (2) in einer Längsrichtung des Leiters (6) durch die Durchgangsöffnung (5) durchführbar ist,
wobei das erste Abtastelement (7) und das zweite Abtastelement (8) derart am Rahmenelement (4) angeordnet sind, sodass die Isolierung des Leiters (3) an einer ersten Seite (9) durch das erste Abtastelement (7) während der Durchführung des Leiters (2) durch die Durchgangsöffnung (5) berührbar ist und die Isolierung des Leiters (3) an einer zweiten Seite (10) während der Durchführung des Leiters (2) durch die Durchgangsöffnung (5) durch das zweite Abtastelement (8) berührbar ist,
wobei die zweite Seite der Isolierung des Leiters (10) der ersten Seite der Isolierung des Leiters (9) gegenüberliegt.

2. Vorrichtung (1) nach Anspruch 1, wobei der Leiter (2) eine Stromschiene ist.

3. Vorrichtung (1) nach Anspruch 1 oder 2, wobei die Vorrichtung ein erstes Führungselement (11) und ein zweites Führungselement (12) zur Führung des elektrischen Leiters (2) entlang zweier gegenüberliegender Seiten des Leiters (2) durch die Durchgangsöffnung (5) aufweist, und
wobei das erste Führungselement (11) und das zweite Führungselement (12) zumindest teilweise innerhalb der Durchgangsöffnung (5) angeordnet sind.

4. Vorrichtung (1) nach Anspruch 3, wobei das erste Führungselement (11) eine rotierbare erste Führungsrolle (13) zur Führung des Leiters (2) durch die Durchgangsöffnung (5) und/ oder das zweite Führungselement (12) eine rotierbare zweite Führungsrolle (14) zur Führung des Leiters (2) durch die Durchgangsöffnung (5) aufweist.

5. Vorrichtung (1) nach einem der vorhergehenden Ansprüche, wobei die Vorrichtung (1), das erste Abtastelement (7), das zweite Abtastelement (8), das erste Führungselement (11), das zweite Führungselement (12) und/ oder das Rahmenelement (4) elektrisch leitend ausgebildet ist und an einer Spannungsquelle angeschlossen ist, um eine Spannungsdifferenz gegenüber dem Leiter (2) anzulegen.

6. Vorrichtung (1) nach einem der vorhergehenden Ansprüche, wobei das erste Abtastelement (7) und/ oder das zweite Abtastelement (8) federnd, insbesondere mittels einer Spiralfeder (15) federnd, mit dem Rahmenelement (4) verbunden ist.

7. Vorrichtung (1) nach einem der vorhergehenden Ansprüche, wobei das erste Abtastelement (7) eine erste rotierbare Rolle (16) und/ oder das zweite Abtastelement (8) eine zweite rotierbare Rolle (17) aufweist.

8. Vorrichtung (1) nach Anspruch 7, wobei die erste Rolle (16) und/ oder die zweite Rolle (17) derart ausgebildet ist, sodass bei der Durchführung des Leiters (2) durch die Durchgangsöffnung (5) die erste Rolle (16) und/ oder die zweite Rolle (17) auf der Isolierung des Leiters (3) abrollbar ist.

9. Vorrichtung (1) nach einem der vorhergehenden Ansprüche, wobei das erste Abtastelement (7) erste Borsten (18) und/ oder das zweite Abtastelement (8) zweite Borsten (19) aufweist.

10. Prüfanordnung (22) zur Prüfung einer Isolierung eines Leiters (3) aufweisend:
einen mehrachsigen Manipulator,
und eine Vorrichtung (1) nach einem der vorherigen Ansprüche,
wobei die Vorrichtung (1) an einem Ende des Manipulators angeordnet ist, und wobei die Vorrichtung (1) mittels des Manipulators entlang des Leiters (2) bewegbar ist.

11. Prüfanordnung (22) nach Anspruch 10, wobei die Prüfanordnung (22) eine erste und eine zweite Vorrichtung (1) nach einem der Ansprüche 1 bis 9 aufweist, und wobei die zweite Vorrichtung (1) mittels zumindest eines, bevorzugt zweier biegeschlaffer Verbindungselemente (20) mit der ersten Vorrichtung (1) verbunden ist.

12. Verfahren zur Prüfung einer Isolierung eines Leiters (3) mittels einer Vorrichtung (1) gemäß einem der Ansprüche 1 bis 9 oder mittels einer Prüfanordnung (22) gemäß Anspruch 10 oder 11 aufweisend die folgenden Schritte:
- Positionierung des zu prüfenden Leiters (2) innerhalb der Durchgangsöffnung (5) der Vorrichtung (1),
- Relatives Bewegen der Vorrichtung (1) und/ oder des Leiters (2) in Längsrichtung des Leiters (6), sodass das erste Abtastelement (7) und das zweite Abtastelement (8) die Isolierung des Leiters (3) während der relativen Bewegung berühren, und
- Bestimmen einer Eigenschaft der Isolierung des Leiters (3) auf Basis einer mittels der Abtastelemente (7, 8) erfassten Messgröße.

13. Verfahren nach Anspruch 12, wobei das Verfahren zusätzlich den folgenden Verfahrensschritt umfasst:
Anlegen einer Differenzspannung zwischen dem ersten Abtastelement (7) und dem zweiten Abtastelement (8) einerseits und der zu prüfenden Leitung (2) andererseits, wobei das Erfassen der Messgröße das Erfassen eines Stromflusses zwischen dem Leiter (2) und dem ersten Abtastelement (7) sowie zwischen dem Leiter (2) und dem zweiten Abtastelement (8) umfasst, und
wobei das Bestimmen einer Eigenschaft der Isolierung des Leiters (3) das Bestimmen einer Konduktivität der Isolierung des Leiters (3) umfasst.
